# EUROPEAN PATENT APPLICATION

(11) **EP 1 786 246 A1**
(43) Date of publication of application: **16.05.2007**
(21) Application number: 06023348.3
(22) Date of filing: 09.11.2006
(51) Int. Cl.: H05K 1/00, H05K 1/05

(54) **Manufacturing method of a three-dimensional circuit board**

(30) Priority: 09.11.2005 JP 2005324696
(71) Applicant: MATSUSHITA ELECTRIC WORKS, LTD., Kadoma-shi, Osaka (JP)
(72) Inventor: Masaki, Yasufumi, Kadoma-shi Osaka (JP); Mutou, Masahide, Kadoma-shi Osaka (JP); Shindou, Takashi, Kadoma-shi Osaka (JP); Kawashima, Masato, Kadoma-shi Osaka (JP); Mori, Yoshio, Kadoma-shi Osaka (JP); Wada, Tsuguo, Kadoma-shi Osaka (JP); Uchinono, Yoshiyuki, Kadoma-shi Osaka (JP); Kaji, Norimasa, Kadoma-shi Osaka (JP)
(74) Representative: Samson & Partner

(57) **Abstract**

In order to obtain a 3D circuit board manufacturing method capable of improving productivity and accuracy of circuit formation, the metal hoop material 1 provided with the positioning pilot holes 2 is employed. Since the 3D structures 3 are formed on the hoop material 1 with a preset interval maintained therebetween in a lengthwise direction of the hoop material 1, the series of processes can be conducted on a roll 1A (winding of the hoop material 1) basis, which results that handling between the individual processes can be done more easily while increase of troubles and manufacturing costs can be prevented. Further, since the positioning pilot holes 2 serve to facilitate accurate positioning, plating and/or laser processing can be conducted continuously with high precision while a tact time for the positioning work can be reduced.

## Description

The present invention relates to a manufacturing method of a three-dimensional (3D) circuit board.

In a conventional manufacturing method of a 3D circuit component, e.g., an MID (Molded Interconnect Device), in general, a conductive layer is deposited on a molded body of an insulator such as resin, and, then, a circuit is selectively formed on the conductive layer by using a laser.

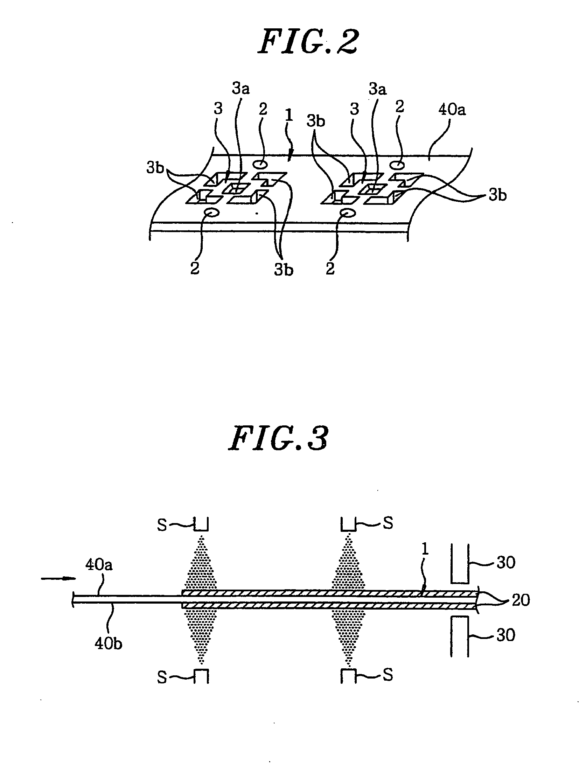

Disclosed in, for example, Japanese Patent Laid-open Application No. 2001-345533 (page 4 and Fig. 2) is a 3D circuit component manufacturing method for improving a production yield by means of preparing a molded body having a plurality of 3D structures formed in a single mold; forming a circuit on each 3D structure by employing the above method; and then dicing the plurality of 3D circuit boards thus formed to separate them from each other.

However, in the above-described conventional 3D circuit board manufacturing method, each molded body having the plurality of 3D structures formed in a single mold is a plate-shaped piece made of an insulator such as resin or ceramic. Thus, a handling mechanism is required to load and arrange the molded bodies on an automated line. As a result, the entire scale of an apparatus for manufacturing the 3D circuit boards is increased as much as the space occupied by the handling mechanism, resulting in an increase of manufacturing costs as well as an installation space (foot print) of the apparatus.

Moreover, in the above method, when forming the circuits on the 3D structures, positioning for laser patterning is carried out through the alignment of the molded bodies. Thus, accuracy of the circuit formation would be degraded, while a tact time is increased due to the time-consuming positioning work.

It is, therefore, an object of the present invention to provide a 3D circuit board manufacturing method, capable of improving productivity and accuracy of circuit formation by forming a multiplicity of 3D structures on a strip-shaped metal hoop material successively and processing the 3D structures to produce 3D circuit boards.

In accordance with the present invention, there is provided a manufacturing method of three-dimensional (3D) circuit boards, including the steps of:
(a) forming 3D structures on a strip-shaped metal hoop material in a lengthwise direction of the metal hoop material;
(b) forming an insulating layer on the metal hoop material on which the 3D structures are formed;
(c) forming a circuit on each of the 3D structures on which the insulating layer is deposited;
(d) cutting and separating the 3D structures on which the circuits are formed.

Preferably, the metal hoop material is provided with cutout portions at spaces between every two neighboring 3D structures.

Preferably, in the step (b), the insulating layer is formed by spray coating.

Preferably, in the step (b), the insulating layer is formed by an aerosol process using insulating particles.

Preferably, the step (c) includes a metal layer forming step (c1) for forming a metal layer on a surface of the insulating layer formed in the step (b), and the metal layer forming step (c1) is carried out by using a dry layer-forming apparatus having a vacuum chamber containing one or more metal targets therein, wherein the metal layer on the surface of the insulating layer is formed by loading the metal hoop material into the vacuum chamber and applying a voltage between the metal targets and the metal hoop material while the metal hoop material is passed through the vacuum chamber.

Preferably, the dry layer-forming apparatus has a plurality of metal targets disposed around the metal hoop material.

Preferably, the step (d) includes a pressing step (d1) for cutting out the 3D structures having the circuits formed thereon from the metal hoop material, to thereby separate the 3D structures from each other and obtain the 3D circuit boards, and in the pressing step (d1), the 3D structures are cut while a support plate is place in close contact with a rear surface of the metal hoop material.

Preferably, a passivation layer is formed on side surfaces of each 3D circuit board obtained in the pressing step (d1).

The above and other objects and features of the present invention will become apparent from the following description of preferred embodiments, given in conjunction with the accompanying drawings, in which:
Fig. 1 is a block diagram schematically illustrating a series of manufacturing processes of a 3D circuit board in accordance with a first preferred embodiment of the present invention;
Fig. 2 provides a perspective view of a metal hoop material on which 3D structures are formed through a 3D structure forming process in accordance with the first preferred embodiment;
Fig. 3 sets forth an explanatory diagram describing an insulating layer forming process in accordance with the first preferred embodiment;
Figs. 4A to 4D depict explanatory diagrams describing a circuit forming process in accordance with the first preferred embodiment;
Fig. 5 is a schematic configuration view of a sputtering device used in a metal layer forming process in accordance with the first preferred embodiment;
Fig. 6 presents an explanatory diagram describing a board separating process in accordance with the first preferred embodiment;
Fig. 7 offers a cross sectional view of a 3D circuit board cut through in the substrate separating process and a support plate in accordance with the first preferred embodiment of the present invention;
Fig. 8 sets forth an explanatory diagram describing a process for forming passivation layers on side surfaces of the separated 3D circuit board;
Fig. 9 presents a perspective view of a hoop material having 3D structures formed thereon in accordance with a second preferred embodiment of the present invention;
Fig. 10 provides an explanatory diagram describing an insulating layer forming process in accordance with a third preferred embodiment of the present invention; and
Fig. 11 is a schematic configuration view showing an arrangement of metal targets of a sputtering device used in a metal layer forming process in accordance with a fourth preferred embodiment of the present invention.
   Hereinafter, preferred embodiments of the present invention will be described in detail with reference to the accompanying drawings.

### (First preferred embodiment)

A 3D circuit board manufacturing method in accordance with the present invention can be applied to the fabrication of 3D circuit components such as MIDs. In this embodiment, a strip-shaped metal hoop material (hereinafter simply referred to as a "hoop material") is utilized as a substrate member. The term "strip-shaped metal hoop material" or simply "hoop material" used herein represents a bendable elongated material made of metal which can be rolled or wound around a reel and supplied therefrom.

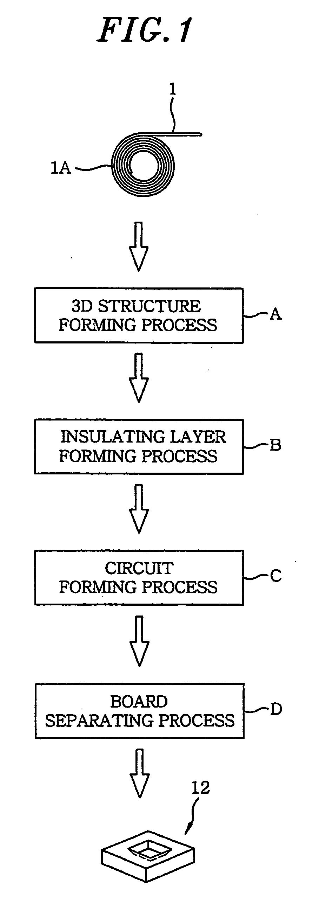

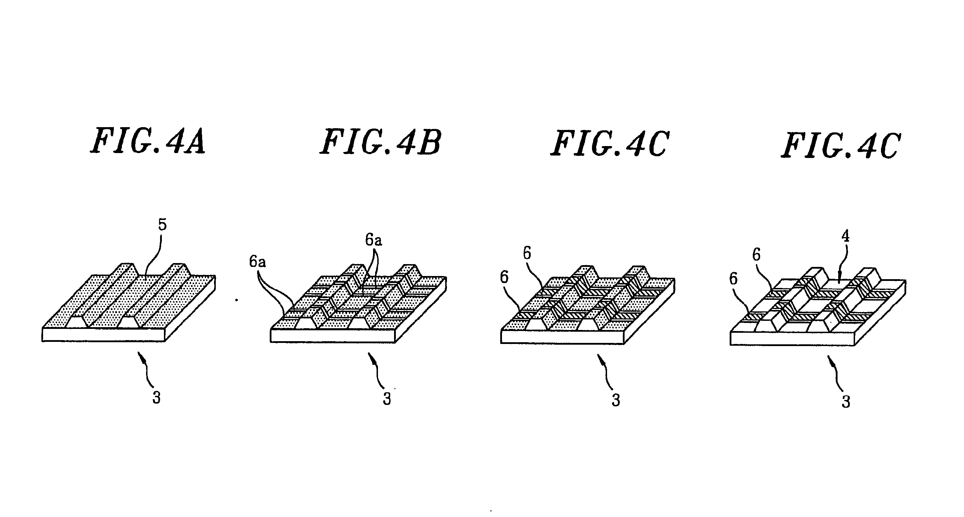

The 3D circuit board manufacturing method in accordance with the first embodiment of the present invention employs, as shown in Fig. 1, a strip-shaped hoop material 1, formed of, e.g., Al, Cu, or an alloy thereof, provided with positioning pilot holes 2 (see Fig. 2). The positioning pilot holes 2 preferably serve as reference points in position aligning process required in the following steps. The method includes: a 3D structure forming process A for forming 3D structures 3 (see Fig. 2) on the hoop material 1 with a preset interval maintained therebetween in a lengthwise direction (extended direction) of the hoop material 1; an insulating layer forming process B for forming insulating layers on the hoop material 1 on which the 3D structures 3 are formed; a circuit forming process C for forming a circuit 4 (see Fig. 4) on each of the 3D structures 3 on which the insulating layers are deposited; and a board separating process D for cutting out and separating the 3D structures 3 on which the circuits are formed. The hoop material 1 is wound to form a roll 1A, before being subjected to each of the processes A to D.

In the 3D structure forming process A, the 3D structures 3 are formed, e.g., on a top surface of the hoop material 1 with the preset interval maintained therebetween in the lengthwise direction of the hoop material 1, as shown in Fig. 2. Each 3D structure 3 has a recess portion 3a formed, e.g., at its central portion through a forging process or the like; and disjointed openings 3b are partially formed around the recess portion 3a by machining, for example. The openings 3b serve to define the contour of each 3D structure. Further, the hoop material 1 is provided with the positioning pilot holes 2, e.g., circular holes, at both sides of each 3D structure in the widthwise direction of the hoop material 1.

In the insulating layer forming process B, insulating layers 20 are spray coated on the hoop material 1 (i.e., a surface 40a and its opposite surface 40b) by injecting a sol-gel solution of ceramic or resin from sprays S installed at both sides of the hoop material 1, e.g., while continuously moving the hoop material 1 from left to right as shown in Fig. 3; and then the coated insulating layers 20 are dried by dryers, e.g., heaters 30, for example.

Further, the circuit forming process C includes a metal (e.g., copper) layer forming (metallizing) step for forming, e.g., by sputtering, a copper layer 5 on the surface of each 3D structure 3 on which the insulating layer has been formed, as shown in Fig. 4A. After the copper layer forming step, circuit patterns 6a are drawn (patterned) by laser, as shown in Fig. 4B. Then, as shown in Fig. 4C, Ni and gold plating are conducted, e.g., only on the copper layer 5 inside the circuit patterns by electroplating, to form thick conductive circuit portions 6. Subsequently, as shown in Fig. 4D, entire surface of the 3D structure is etched to remove the sputtered layer outside the conductive circuit portion 6, thus finally obtaining a circuit 4.

Moreover, though the 3D structures 3 in Figs. 4A to 4D are depicted differently from those shown in Fig. 2 in their specific configurations for the sake of simplicity, the circuits 4 are all formed through a basically same process.

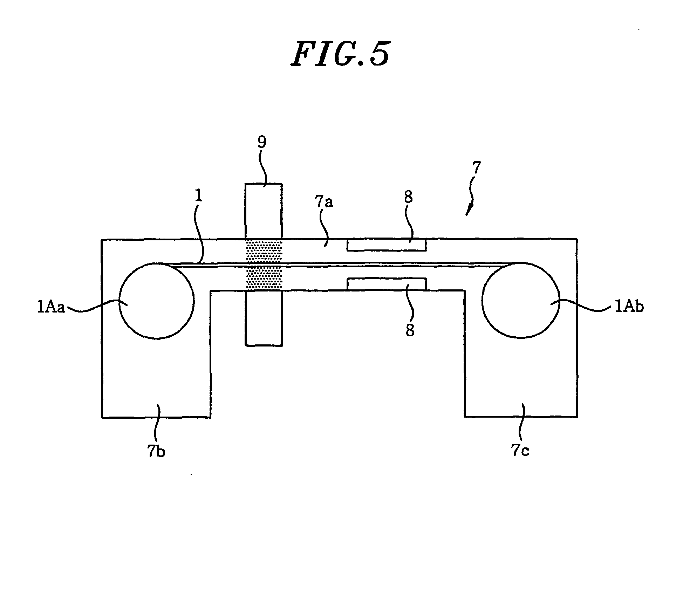

For the metal layer forming step in the circuit forming process C, a sputtering device 7 shown in Fig. 5 can be used as a dry layer-forming apparatus, for example. In the sputtering device 7, the hoop material 1 is passed through a vacuum chamber 7a having metal (copper) targets 8 arranged therein, during which a metal (copper) layer is formed on the hoop material 1 by a voltage applied between the metal targets 8 and the hoop material 1.

That is, in the sputtering device 7, a discharge is generated in a vacuum by the voltage applied between the hoop material 1 and the metal targets 8 disposed at both sides of the hoop material 1 (i.e., the upper and lower sides of the hoop material 1). As a result, a residual gas is ionized, and the gas ions are made to collide with the metal targets 8. As a result of the collision with the gas ions, metal atoms of the metal targets 8 are sputtered therefrom to be stuck to the hoop material 1, thus forming metal layers thereon.

The sputtering device 7 has housing chambers 7b and 7c for accommodating therein a supply reel 1Aa for supplying the hoop material 1 and a take-up reel 1Ab for receiving the hoop material 1 from the vacuum chamber 7a and winding thereon the hoop material 1 in the vacuum, respectively. Further, the vacuum chamber 7a has an ion guns 9 (or a plasma processing alternatively) for cleaning the hoop material 1 being conveyed to the metal targets 8. As for the metal targets 8, it is possible to employ plural types of targets in order to form multiple layers, not restricted to a single layer.

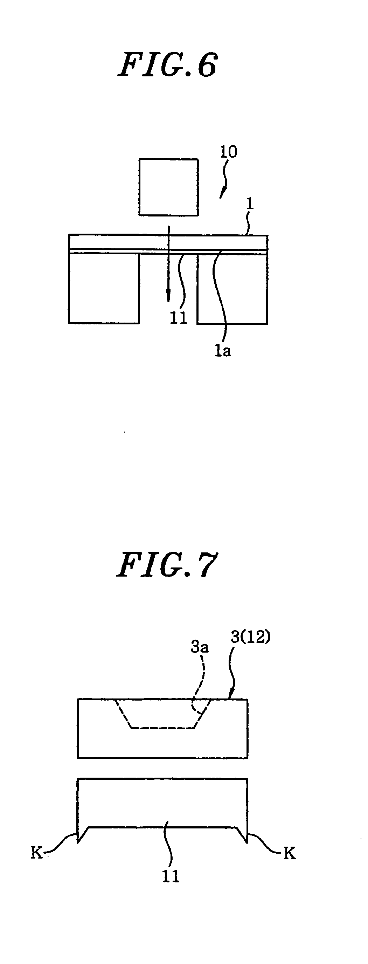

Further, the substrate separating process D includes a pressing step for cutting and separating the 3D structures 3 having the circuits formed thereon by using, e.g., a pressing machine 10, as shown in Fig. 6. The pressing step is performed while a support plate 11 is placed in close contact with the rear surface 1a of the hoop material 1.

Accordingly, 3D circuit boards 12 are obtained by cutting out the 3D structures 3 from the hoop material 1 by means of the pressing machine 10; and at this time, parts of the support plate 11 under the 3D structures 3 are also cut out together with the 3D circuit boards 12, while having the same shapes as those of the 3D circuit boards 12, as shown in Fig. 7.

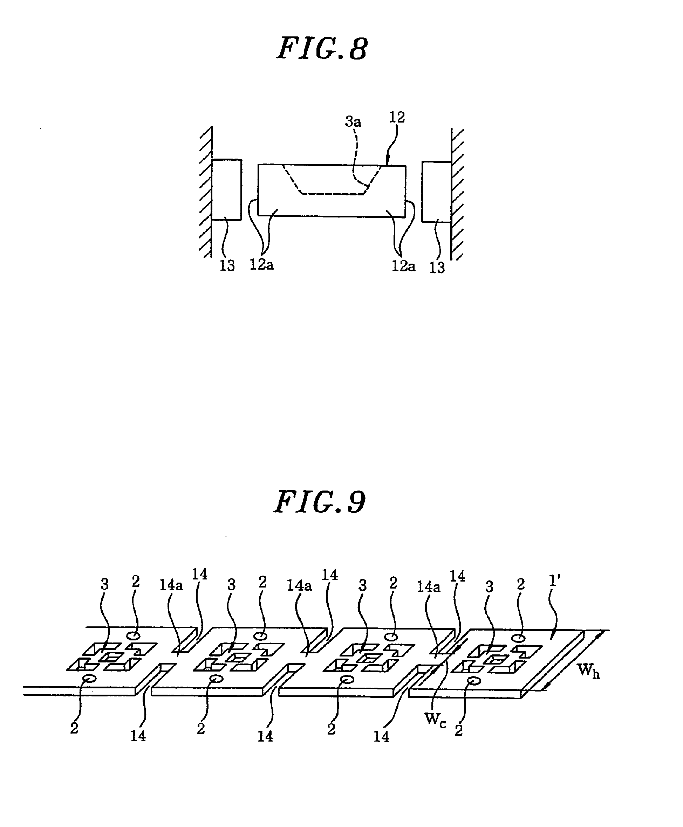

Also, as shown in Fig. 8, side surfaces 12a of each 3D circuit board 12 are thermally oxidized by means of heating units 13, so that passivation layer is formed on the metal surfaces exposed thereat. Further, the formation of the passivation layer can also be achieved by, for example, performing an oxygen plasma processing, instead of using the heating units 13.

Accordingly, in accordance with a 3D circuit board manufacturing method in accordance with the first preferred embodiment using the strip-shaped hoop material 1 as a substrate material for the 3D circuit boards 12, the 3D structures 3 can be easily and smoothly moved to be subjected to each of the series of processes including the 3D structure forming process A, the insulating layer forming process B, the circuit forming process C and the board separating process D. Also, since the series of processes can be conducted on a roll 1A (winding of the hoop material 1) basis, handling between the individual processes can be done more easily, and increase of equipment size and manufacturing costs can be prevented.

Further, the positioning pilot holes 2 serve to facilitate accurate positioning. Thus, in the circuit forming process C in particular, plating and/or laser processing can be conducted continuously with high precision Also, a tact time for the positioning work can be reduced.

In addition, due to the use of the hoop material 1, the 3D circuit boards 12 are metal based, so that heat resistance and heat dissipation property of the 3D circuit boards 12 can be improved. In this regard, the use of the hoop material 1 can add merits to final products in addition to its advantages in the manufacturing process.

Furthermore, since the insulating layers are spray coated on both sides of the hoop material 1 by way of injecting the sol-gel solution of ceramic or resin from the sprays S disposed at both sides of the hoop material 1, building up of liquid causing problems in a dip coating process can be prevented, so that the thickness of the insulating layers can be made uniform.

Moreover, since the metal layers are formed on the surfaces of the insulating layers by sputtering the target materials from the metal targets 8 by applying a voltage between the metal targets 8 and the hoop material 1 through the use of the sputtering device 7, a roughening process for the insulating layers' surfaces on which the metal layers are formed is not needed. Further, since the layer formation can be continuously conducted in vacuum, highly adhesive metal layers can be obtained.

Also, in this preferred embodiment, since the 3D structures 3 are cut out and separated by the pressing machine 10 while the support plate 11 is placed in close contact with the rear surface 1a of the hoop material 1, as shown in Fig. 7, burrs K are generated at the cutoff portions of the support plate 11 instead of the cut 3D circuit boards 12.

Further, since the passivation layers are formed on the side surfaces 12a of the 3D circuit boards 12, the metals exposed through the side surfaces 12a can be protected by the passivation layers. Therefore, corrosion of the exposed metal surfaces can be prevented.

### (Second preferred embodiment)

Referring to Fig. 9, there is provided a perspective view of a hoop material 1' on which 3D structures are formed in accordance with a 3D circuit board manufacturing method of a second preferred embodiment of the present invention. In the following, like parts to those described in the first embodiment will be designated by like reference symbols, and description thereof will be omitted.

The 3D circuit board manufacturing method in accordance with the second embodiment is basically identical to the first embodiment. As in the first embodiment, the hoop material 1' provided with positioning pilot holes 2 is used as a substrate material, and 3D structures 3 are formed on the hoop material 1' with the preset interval maintained therebetween in a lengthwise direction of the hoop material 1'. The distinctive feature of the second embodiment is that the hoop material 1' has cutout portions 14 formed at regions where the 3D structures 3 are not formed. That is, in the second embodiment, the cutout portions 14 are formed at both widthwise sides of each of spaces between every two neighboring 3D structures 3.

Further, in each space between the neighboring 3D structures, a pair of cutout portions is formed at both widthwise sides of the hoop material 1' to make the cutout portions of each pair face each other with a widthwise central portion of the hoop material 1' left therebetween. The residual portion of each space forms a connection portion 14a having a predetermined width W_{c} at the widthwise central portion of the space (W_{c} being smaller than the width Wₕ of the hoop material 1'). Therefore, portions of the hoop material 1' on which the 3D structures are formed are connected to their neighboring ones in the lengthwise direction via the connection portions 14a.

Accordingly, in accordance with the second embodiment, since the hoop material 1' can be bent easily due to the presence of the cutout portions 14 formed thereat, the diameter of the roll 1A is reduced when winding the hoop material 1, so that a size reduction of a manufacturing apparatus, e.g., the sputtering device 7 shown in Fig. 5 can be achieved. Further, as the hoop material 1 can be easily twisted, degree of freedom in the layout of processing devices (e.g., sprays) in each process increases, thus contributing to the size reduction of the manufacturing apparatus.

### (Third preferred embodiment)

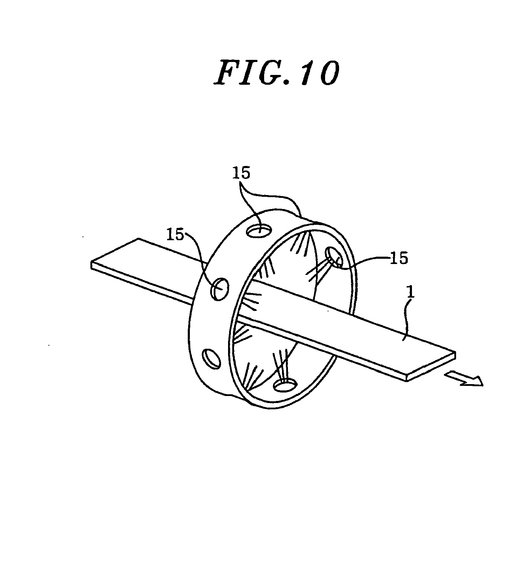

Fig. 10 is a drawing for describing the insulating layer forming process in accordance with a third preferred embodiment of the present invention. Here, like parts to those described in the first embodiment will be assigned like reference symbols, and description thereof will be omitted.

As in the first preferred embodiment, a 3D circuit board manufacturing method in accordance with the third embodiment includes the insulating layer forming process B in which insulating layers are deposited on a hoop material 1 having 3D structures formed thereon. The distinctive feature of the third embodiment is that the insulating layers are deposited by an aerosol process using insulating fine particles in the insulating layer forming process B.

Specifically, in this preferred embodiment, ceramic is used as the fine particles of the insulator. The ceramic fine particles are mixed with volatile aerosol and are injected toward the hoop material 1 through a plurality of aerosol injection holes 15 disposed around the hoop material 1, as shown in Fig. 10, so that ceramic insulting layers are formed on the hoop material 1.

Since the ceramic fine particles are injected all around the hoop material 1, ceramic insulating layers of uniform thickness can be formed on all surfaces of the 3D structures including their sidewall portions.

As described, since the insulating layers are formed through the aerosol process using the insulating fine particles in the third embodiment of the present invention, a drying process and a waste fluid treatment are not needed after completing the coating of the insulating layers.

### (Fourth preferred embodiment)

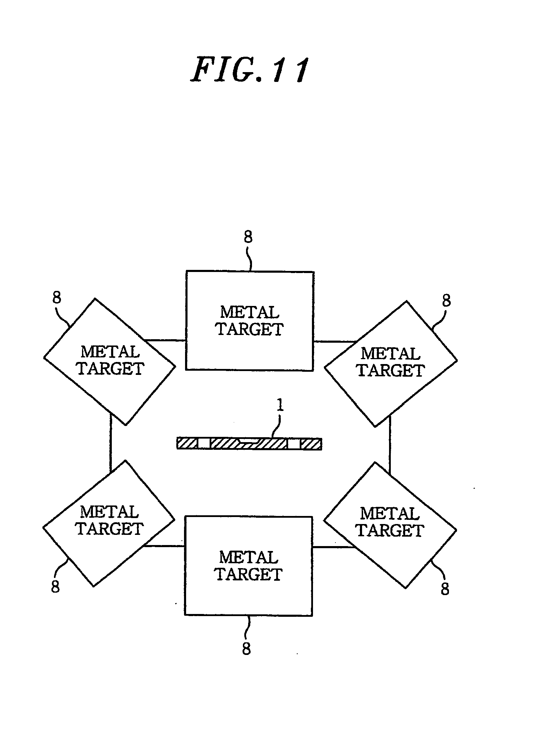

Referring to Fig. 11, there is provided a schematic configuration view showing an arrangement of metal targets of a sputtering device employed in the metal layer forming process. In the following description, like parts to those described in the first embodiment will be assigned same reference symbols, and their explanation will be omitted.

A 3D circuit board manufacturing method in accordance with the fourth embodiment includes the metal forming process basically identical to that described in the first embodiment, in which a metal layer is formed by means of the sputtering device 7 shown in Fig. 5. In the fourth embodiment, however, plural (e.g., six) metal targets 8 are arranged around a hoop material 1, so that sputtering can be uniformly carried out on the 3D structures on the hoop material 1 in all directions.

As a result, layers can be formed on all surfaces of the 3D structures 3 including their side surfaces with a substantially uniform thickness.

While the invention has been shown and described with respect to the preferred embodiments, it will be understood by those skilled in the art that various changes and modifications may be made without departing from the spirit and scope of the invention as defined in the following claims.

## Claims

1. A manufacturing method of three-dimensional (3D) circuit boards, comprising the steps of:
(a) forming 3D structures on a strip-shaped metal hoop material in a lengthwise direction of the metal hoop material;
(b) forming an insulating layer on the metal hoop material on which the 3D structures are formed;
(c) forming a circuit on each of the 3D structures on which the insulating layer is deposited;
(d) cutting and separating the 3D structures on which the circuits are formed.

2. The method of claim 1, wherein the metal hoop material is provided with cutout portions at spaces between every two neighboring 3D structures.

3. The method of claim 1 or 2, wherein in the step (b), the insulating layer is formed by spray coating.

4. The method of claim 1 or 2, wherein in the step (b), the insulating layer is formed by an aerosol process using insulating particles.

5. The method of any one of claims 1 to 4, wherein the step (c) includes a metal layer forming step (c1) for forming a metal layer on a surface of the insulating layer formed in the step (b), and the metal layer forming step (c1) is carried out by using a dry layer-forming apparatus having a vacuum chamber containing one or more metal targets therein, wherein the metal layer on the surface of the insulating layer is formed by loading the metal hoop material into the vacuum chamber and applying a voltage between the metal targets and the metal hoop material while the metal hoop material is passed through the vacuum chamber.

6. The method of claim 5, wherein the dry layer-forming apparatus has a plurality of metal targets disposed around the metal hoop material.

7. The method of any one of claims 1 to 6, wherein the step (d) includes a pressing step (d1) for cutting out the 3D structures having the circuits formed thereon from the metal hoop material, to thereby separate the 3D structures from each other and obtain the 3D circuit boards, and in the pressing step (d1), the 3D structures are cut while a support plate is place in close contact with a rear surface of the metal hoop material.

8. The method of claim 7, wherein a passivation layer is formed on side surfaces of each 3D circuit board obtained in the pressing step (d1).
